# FASCICULE DE BREVET EUROPEEN

(11) **EP 1 476 588 B1**
(45) Date de publication et mention de la délivrance du brevet: **20.09.2006**
(21) Numéro de dépôt: 03735758.9
(22) Date de dépôt: 19.02.2003
(51) Int. Cl.: C23G 5/00, B08B 7/00, H01J 37/32

(54) **PROCEDE DE NETTOYAGE DE LA SURFACE D UN MATERIAU ENDUIT D UNE SUBSTANCE ORGANIQUE, GENERATEUR ET DISPOSITIF DE MISE EN OEUVRE**
VERFAHREN ZUM REINIGEN EINER MATERIALOBERFLÄCHE BESCHICHTET MIT EINER ORGANISCHEN SUBSTANZ, GENERATOR UND EINRICHTUNG ZUR DURCHFÜHRUNG DES VERFAHRENS
METHOD OF CLEANING THE SURFACE OF A MATERIAL COATED WITH AN ORGANIC SUBSTANCE AND A GENERATOR AND DEVICE FOR CARRYING OUT SAID METHOD

(30) Priorité: 19.02.2002 FR 0202047
(43) Date de publication de la demande: 17.11.2004
(73) Titulaire: ARCELOR France, 93200 Saint Denis (FR)
(72) Inventeur: CHALEIX, Daniel, F-57220 Roupelange (FR); CHOQUET, Patrick, F-57050 Longeville les metz (FR); BARAVIAN, Gérard, F-91470 Limours (FR); LACOUR, Bernard, F-91240 Saint Michel Sur Orge (FR); PUECH, Vincent, F-92100 Boulogne-Billancourt (FR)
(74) Mandataire: Lagrange, Jacques Etienne M.M.
(86) Numéro de dépôt international: PCT/FR2003/000541
(87) Numéro de publication internationale: WO 2003/078692

(56) Documents cités:
- DE-A- 4 332 866
- US-A- 2 867 912
- US-A- 5 529 631
- US-A- 5 938 854
- US-A- 5 968 377
- KORZEC D ET AL: "CLEANING OF METAL PARTS IN OXYGEN RADIO FREQUENCY PLASMA: PROCESS STUDY" JOURNAL OF VACUUM SCIENCE AND TECHNOLOGY: PART A, AMERICAN INSTITUTE OF PHYSICS. NEW YORK, US, vol. 12, no. 2, 1 mars 1994 (1994-03-01), pages 369-378, XP000442717 ISSN: 0734-2101

## Description

La présente invention concerne un procédé de nettoyage de la surface d'un matériau enduit d'une substance organique, un générateur particulier et un dispositif pour la mise en oeuvre de ce procédé. Ce procédé est plus particulièrement destiné au nettoyage de tôles métalliques, sans y être limité.

En effet, les tôles issues des différentes filières de fabrication existantes sont généralement recouvertes d'un film d'huile qui peut avoir deux origines. Tout d'abord, ce film peut avoir été appliqué à partir d'un spray d'huile de protection, afin de protéger la surface de la tôle contre la corrosion. Mais il peut également s'agir d'un film résiduel d'huile dans le cas des tôles provenant du laminoir à froid ou du skin-pass. Dans les deux cas, les grammages en huile sont de l'ordre de la centaine de mg par m².

La réalisation d'un dépôt métallique ou organique sur ces tôles nécessite l'élimination du film d'huile lors d'une opération de nettoyage ou de dégraissage puis d'avivage, pour obtenir une bonne adhérence de ce revêtement. Les techniques généralement utilisées dans ce but sur les lignes industrielles présentent la contrainte de ne pas échauffer la tôle outre mesure, afin de conserver les propriétés mécaniques de la bande d'acier.

Ainsi, la plus courante de ces techniques consiste en un dégraissage alcalin assisté ou non par un procédé électrolytique. Pour des raisons environnementales, ce procédé nécessite l'installation d'ateliers annexes complexes pour le retraitement des co-produits éco-toxiques.

D'autres solutions techniques permettent d'éviter la formation de ces co-produits, comme par exemple, l'ablation laser qui a pour effet de désorber les composés organiques par voie photochimique, mais actuellement, elle ne permet pas encore de traiter des bandes à des vitesses dépassant quelques mètres par minute par manque de puissance des lasers.

Par ailleurs, US 5 529 631 enseigne qu'une technique avantageuse de traitement de surface consiste à utiliser un plasma à haute pression, réalisé grâce à des décharges à barrière diélectrique dans des mélanges gazeux contenant majoritairement de l'hélium. Ce gaz rare est en effet nécessaire pour obtenir une décharge luminescente stable, évitant ainsi de passer en régime d'arc qui mènerait à un traitement non homogène. La teneur en hélium doit dans ce cas, être supérieure à 70% en volume, ce qui implique que la teneur en oxygène est limitée. Les exemples cités dans le brevet montrent qu'un traitement par plasma effectué en continu, dans ces mélanges gazeux, est alors suffisant pour augmenter l'énergie de surface d'un polymère. Mais, dans le cas d'un traitement plasma utilisé pour nettoyer une surface métallique, ce sont uniquement les espèces réactives de l'oxygène (O° , etc...) formées dans le plasma qui oxydent l'huile enduisant la tôle qui permettent la transformation des chaînes carbonées en espèces volatiles. On constate donc que le traitement n'est pas suffisamment rapide, probablement en raison de la faible densité d'espèces oxygénées réactives si l'on utilise des décharges électriques avec des mélanges gazeux contenant des teneurs égales ou inférieures à 30% en volume d'oxygène.

Pour résoudre ce problème, le brevet US 5 968 377 décrit un procédé de traitement de surface par plasma à pression atmosphérique dans lequel un champ électrique pulsé est imposé entre les électrodes. L'imposition d'un champ électrique pulsé permet de couper la décharge avant qu'elle ne passe en régime d'arc et de la ré-initier à l'instant suivant. Les impulsions de tension appliquées présentent la particularité d'être symétriques. Mais, les présents inventeurs ont constaté que ce procédé n'était pas utilisable pour le nettoyage d'un matériau enduit d'une substance organique. En effet, on observe dans ce cas, qu'une partie seulement de la substance organique est oxydée puis volatilisée et qu'une autre partie polymérise. Le film ainsi formé en surface ne peut être que partiellement éliminé, après un temps important d'immersion dans le plasma.

Le but de la présente invention est donc de remédier aux inconvénients des procédés de l'art antérieur en mettant à disposition un procédé permettant de nettoyer en continu la surface d'un substrat sans obtenir de co-produits éco-toxiques, avec une vitesse de traitement supérieure à 10 m/min.

A cet effet, un premier objet de l'invention est constitué par un procédé de nettoyage en continu de la surface d'un matériau enduit d'une substance organique, caractérisé en ce qu'il comprend les étapes consistant à introduire ledit matériau dans une zone de traitement alimentée par un flux gazeux comprenant de l'oxygène, à mettre ledit matériau à la masse, et à générer un plasma en imposant un champ électrique entre la surface dudit matériau et au moins une électrode recouverte de diélectrique, ledit champ électrique étant pulsé et comprenant une succession d'impulsions de tension positives et négatives par rapport audit matériau, la tension maximale des impulsions positives U+ étant supérieure à la tension d'amorçage de l'arc Ua, et la tension maximale des impulsions négatives U- en valeur absolue étant inférieure à la tension d'amorçage Ua.

Les présents inventeurs ont notamment constaté que l'impulsion positive devait être assez haute, soit supérieure en valeur absolue à la tension d'amorçage de l'arc Ua, pour créer un plasma suffisamment dense dans la zone de traitement, pour atteindre des vitesses de nettoyage élevées.

Ils ont également constaté qu'il était indispensable que la tension maximale des impulsions négatives U-, en valeur absolue, soit inférieure à la tension d'amorçage Ua, pour ne pas déclencher une décharge électrique entre les deux électrodes, car l'utilisation d'une tension négative trop importante conduit à une polymérisation de l'huile, ne permettant pas d'obtenir un bon dégraissage.

La valeur de tension d'amorçage de l'arc est principalement fonction de la pression du gaz dans le réacteur et de la distance inter-électrodes. Ces paramètres sont reliés par la loi de Paschen.

Le procédé selon l'invention peut en outre présenter les caractéristiques suivantes, seules ou en combinaison :
- le front de montée en tension dudit champ est inférieur ou égal à 600 ns, de préférence à 60 ns,
- la fréquence des impulsions positives est supérieure ou égale à 20 kHz,
- le flux gazeux est constitué d'air ou d'oxygène,
- le matériau est un matériau métallique, de préférence un acier au carbone,
- la substance organique est une huile de protection temporaire contre la corrosion, ou une émulsion mécanique instable (mélange huile+eau) issue, par exemple, de l'opération de laminage (skin-pass) du matériau métallique,
- le matériau est sous forme d'une bande en défilement, et les différentes étapes du procédé sont réalisées en continu au moyen d'installations disposées successivement sur le trajet de la bande en défilement.

Un second objet de l'invention est constitué par un générateur pouvant être utilisé pour la mise en oeuvre du procédé selon l'invention et qui comprend une source d'alimentation basse tension délivrant des impulsions basse tension de tension inférieure à 1000 V à une fréquence de 1 à 200 kHz, et des composants permettant de transformer lesdites impulsions basse tension en impulsions haute tension. Le front de montée en tension de ce générateur est de préférence inférieur ou égal à 600 ns, et de façon plus particulièrement préférée, inférieur ou égal à 60 ns.

Ce générateur se différencie de celui décrit dans le brevet US 5 968 377, car il permet d'obtenir des impulsions dissymétriques de tension. Ceci est possible, car, par opposition au générateur décrit dans US 5 968 377, on ne réalise pas de découpage des impulsions à haute tension, mais à basse tension, puis on amplifie le signal grâce aux transformateurs. Dans le cadre de la présente invention, on entend par basse tension, une tension inférieure à 1000 V.

Un troisième objet de l'invention est constitué par un dispositif de mise en oeuvre du procédé selon l'invention qui comprend des moyens de défilement de la bande reliés à la masse, une série d'électrodes recouvertes de diélectrique disposées en face de la surface à traiter de ladite bande, ces électrodes étant reliées à un générateur selon l'invention, des moyens d'alimentation en gaz disposés à proximité de la surface de la bande, et des moyens d'extraction des gaz de décomposition de la substance organique enduisant la bande.

Dans le cadre de la présente demande, on entend par diélectrique un matériau présentant une constante diélectrique supérieure à 6. On entend en outre par substance organique, tout composé contenant au moins du carbone, de l'hydrogène et de l'oxygène. Le front de montée est défini comme étant le temps pendant lequel la tension continue d'augmenter jusqu'à atteindre son maximum.

L'invention va être illustrée par la description d'un mode de réalisation donné à titre indicatif, et non limitatif, en référence aux dessins annexés sur lesquels :
- la figure 1 représente une vue schématique d'un dispositif de traitement selon l'invention,
- la figure 2A représente le schéma de principe de l'alimentation électrique de puissance du dispositif et la figure 2B représente son schéma synoptique,
- la figure 3 représente un oscillogramme des variations de tension obtenues avec un générateur selon l'invention,
- la figure 4 représente l'évolution du pourcentage de réflectivité (%R) d'échantillons calibrés en grammage d'huile dans la bande de longueur d'onde correspondant aux stretchings de la bande CH,
- la figure 5 représente la courbe d'étalonnage établie à partir des enregistrements IRRAS traités mathématiquement,
- la figure 6 indique l'évolution du grammage G en huile résiduelle en fonction du temps de traitement sur des échantillons initialement enduits de 100 mg/m² d'huile,
- la figure 7 indique l'évolution du grammage G en huile résiduelle en fonction du temps de traitement sur des échantillons initialement enduits de 53 mg/m² d'huile,
- la figure 8 indique l'évolution du grammage G en huile résiduelle en fonction du temps de traitement sur des échantillons initialement enduits de 110 mg/m² d'huile.

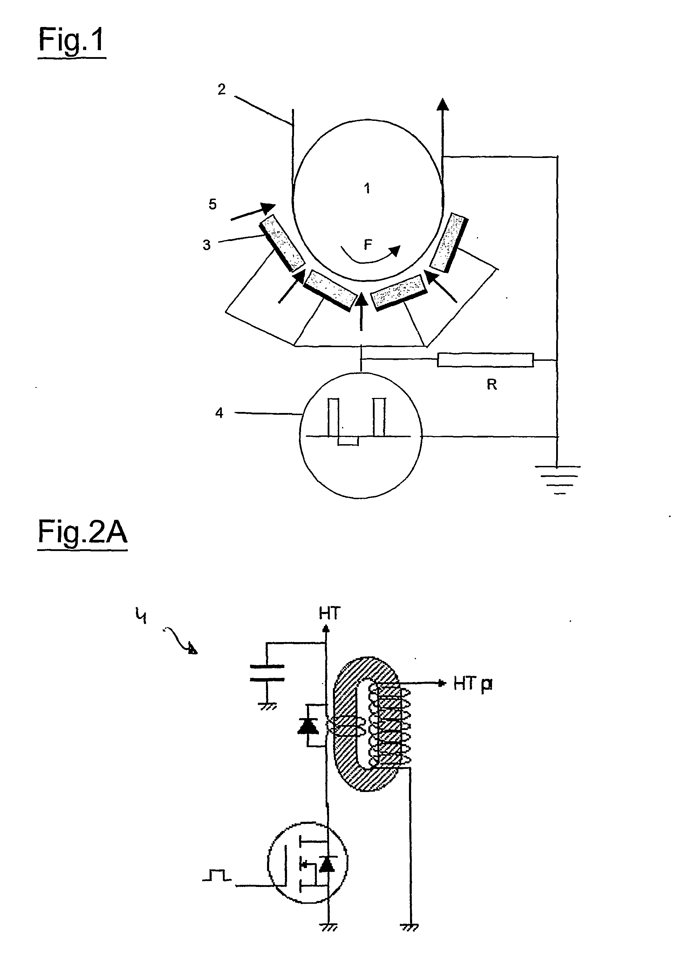

La figure 1 représente un dispositif de traitement qui comprend un cylindre rotatif de support 1 pour une bande d'acier 2 recouverte d'une huile de protection contre la corrosion, que l'on souhaite dégraisser. Ce cylindre 1 tourne dans le sens indiqué par la flèche F et peut éventuellement être refroidi, si nécessaire. Il est relié à la masse par l'intermédiaire de la bande 2.

En face du cylindre 1 sont disposées plusieurs électrodes 3 refroidies et revêtues d'un diélectrique. On choisira de préférence une céramique, telle que l'alumine ou les stumatites par exemple, car elles sont à même de supporter des températures élevées. On choisira un diélectrique dont la constante diélectrique est supérieure à 6, ce qui est le cas de l'alumine, dont la constante diélectrique est comprise entre 8 et 10, mais aussi des stumatites dont la constante est comprise entre 6 et 8.

Chaque électrode 3 est alimentée par un générateur haute tension 4 selon l'invention. Le gaz ou le mélange de gaz de traitement peut être alimenté de différentes manières, et en particulier, il peut être introduit de part et d'autre des électrodes 3 par une rampe 5. On prévoit également un dispositif d'extraction des gaz et des espèces volatiles provenant de la décomposition du film d'huile, de chaque côté du dispositif (non représentés). Afin de faciliter l'alimentation en gaz de la zone, il pourra s'avérer avantageux de circonscrire la zone de traitement dans une enceinte entourant la tôle et les électrodes.

La bande d'acier 2 est reliée à la masse et joue ainsi le rôle d'une contre-électrode. Elle défile sur le cylindre 1 et expose l'une de ses surfaces à l'action des espèces réactives créées par l'action de la décharge sur le gaz de traitement, et qui sont en particulier des espèces oxygénées de type O°.

La décharge électrique est alimentée par le générateur 4 délivrant, pour une fréquence pouvant varier de 1 à 200 kHz, des impulsions de tension de monopolarité dont la forme dépend de la charge sur laquelle cette alimentation débite.

La figure 2A représente le type de circuit électrique de l'alimentation à tension pulsée, qui utilise un transistor MOS de puissance relié à un transformateur élévateur.

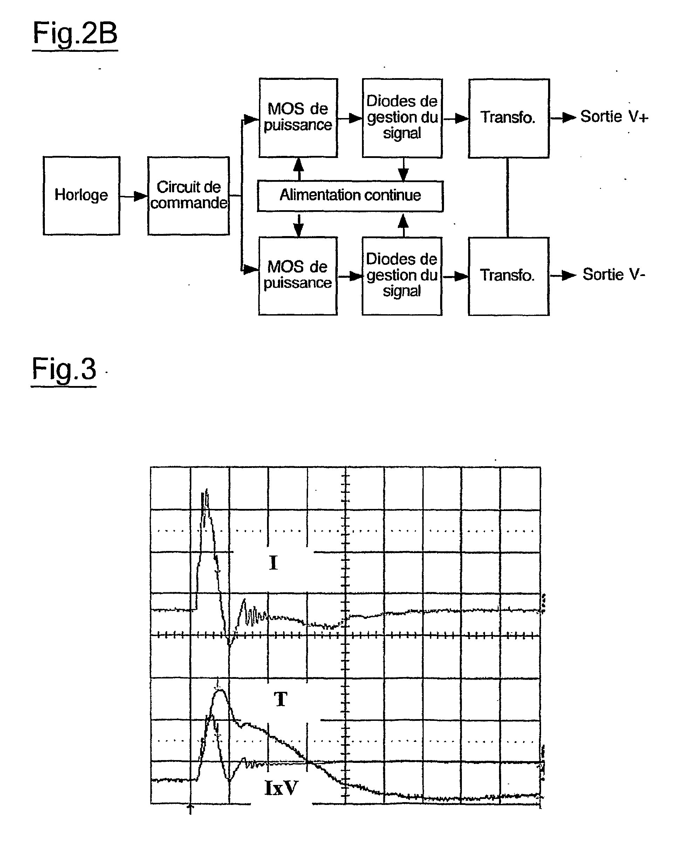

La figure 2B montre le schéma synoptique de l'alimentation conçue spécifiquement pour cette application. Elle se constitue d'un bloc de diodes rapides dont le rôle est de gérer les inversions de tension et de courant dans les transistors de puissance et dans les transformateurs de façon à réduire les pertes ohmiques. Les transformateurs font l'objet d'un montage spécifique afin d'obtenir une faible conductance, une absence de saturation du matériau magnétique et une faible capacité parasite.

La figure 3 comporte une courbe représentant les variations de la tension pendant une succession de deux impulsions telles qu'elles sont délivrées par un générateur selon l'invention.

On voit que la première impulsion de tension est positive et dure environ 1,8 µs, et est suivie d'une impulsion négative, d'amplitude plus faible, et qui dure 48,2 µs. La tension maximale de l'impulsion positive U+ vaut ici 12,7 kV et la valeur maximale de l'impulsion négative en valeur absolue U-vaut 1,8 kV. Le réacteur de traitement utilise une décharge à barrière diélectrique (Al₂O₃) et la distance inter-élecrodes est réglée à 3 mm.

Lors de l'impulsion de tension positive délivrée par le générateur électrique sur l'électrode recouverte du diélectrique, on enregistre une impulsion de courant positif qui est suivie 4 µs plus tard d'une impulsion de courant négatif, d'amplitude plus faible. Ensuite, le courant est pratiquement nul lorsque la tension mesurée sur le diélectrique est négative. Le front de montée de la tension positive est de l'ordre de 400 ns. Une telle valeur du front de montée de la tension permet d'amorcer la décharge sous une tension minimale de 5 KV.

### Exemple 1

On traite deux échantillons d'une bande d'acier doux enduites d'une huile (Quaker Tinnol N200) de protection contre la corrosion, en les soumettant à un champ électrique pulsé selon l'invention afin de les dégraisser. Le grammage d'huile est respectivement sur chacune des tôles de 100 mg/m² et 53 mg/m². Le traitement est effectué en présence d'un flux de 30 I/min d'oxygène, et sous pression atmosphérique.

Le réacteur de traitement utilise une décharge à barrière diélectrique (Al₂O₃) pouvant contenir deux électrodes rectangulaires de dimensions 25x200 mm². La distance inter-élecrodes est de 3 mm.

On effectue différentes durées de traitement plasma sur des échantillons prélevés dans chacune des deux tôles. On mesure ensuite le grammage résiduel en huile de protection sur chaque échantillon traité, par spectroscopie d'absorption infrarouge en incidence rasante (IRRAS).

Préalablement à ces mesures expérimentales, on établit une courbe d'étalonnage à partir d'échantillons calibrés en titre de grammage avec la même huile (Quaker Tinnol N200) sur le même analyseur IRRAS.

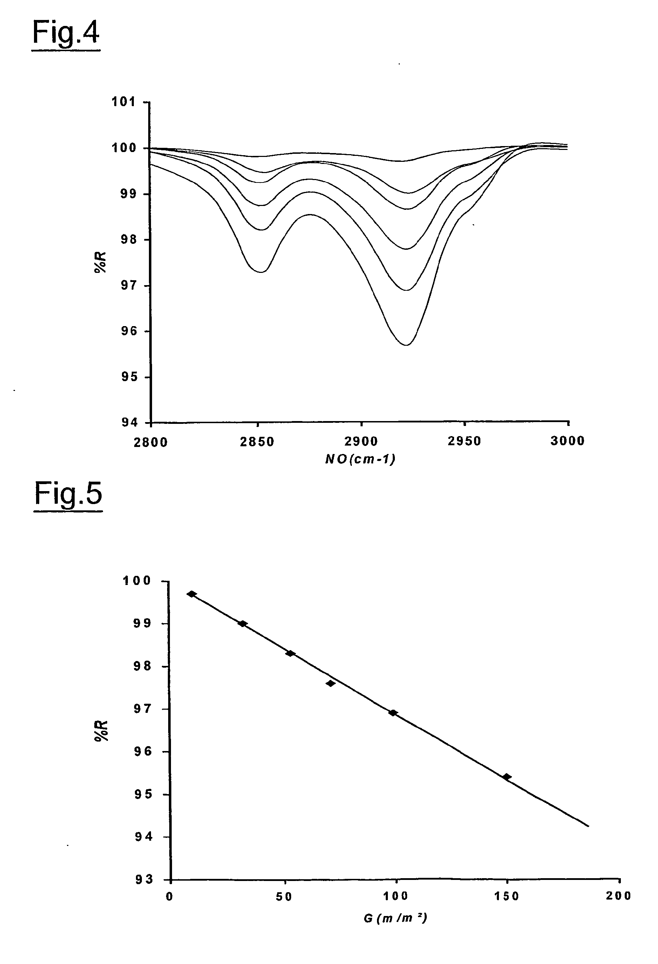

La figure 4 représente l'évolution du pourcentage de réflectivité (%R) d'échantillons calibrés en grammage d'huile, dans la gamme du nombre d'onde (exprimé en cm⁻¹) correspondant aux stretchings de la bande CH. Les échantillons calibrés comportent, en partant de la courbe la plus proche de l'horizontale, 10 mg/m², 32 mg/m², 50 mg/m², 71 mg/m², 100 mg/m² et 150 mg/m² d'huile. L'absence d'huile sur l'échantillon induit un pourcentage de réflectivité de 100%.

La figure 5 présente la courbe d'étalonnage établie à partir des enregistrements IRRAS faits pour chaque échantillon calibré.

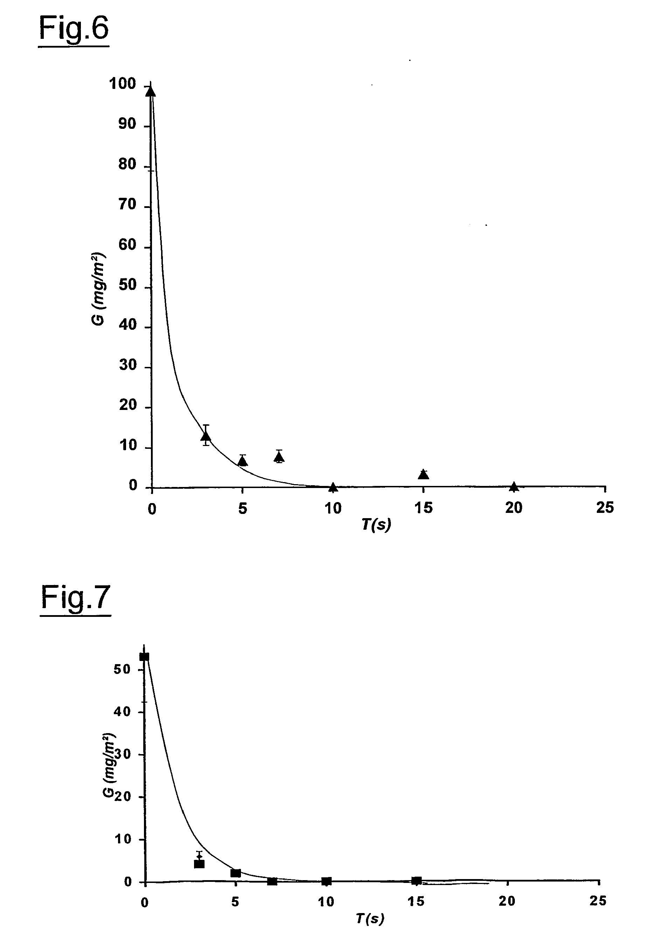

La figure 6 montre l'évolution du grammage en huile résiduelle sur les échantillons prélevés dans la tôle avec 100 mg/m² d'huile après différents temps de traitement plasma, à une fréquence de 100 kHz. On constate qu'un temps de 7 à 8 secondes est suffisant pour nettoyer la tôle.

La figure 7 montre l'évolution du grammage en huile résiduelle sur les échantillons prélevés dans la tôle avec 53mg/m² d'huile après différents temps de traitement plasma, à une fréquence de 100 kHz. On constate qu'un temps de 3 à 4 secondes est suffisant pour nettoyer la tôle.

### Exemple 2

On traite une tôle d'acier doux huilée et skin-passée afin de la nettoyer avec le même réacteur et dans les mêmes conditions expérimentales que celles décrites dans l'exemple 1. Le grammage d'huile sur la tôle est de 110 mg/m².

On effectue différentes durées de traitement plasma sur des échantillons prélevés dans la tôle skin-passée. Ensuite, selon la méthode décrite dans l'exemple 1, on mesure le grammage résiduel en huile sur chaque échantillon traité par spectroscopie d'absorption infrarouge en incidence rasante (IRRAS).

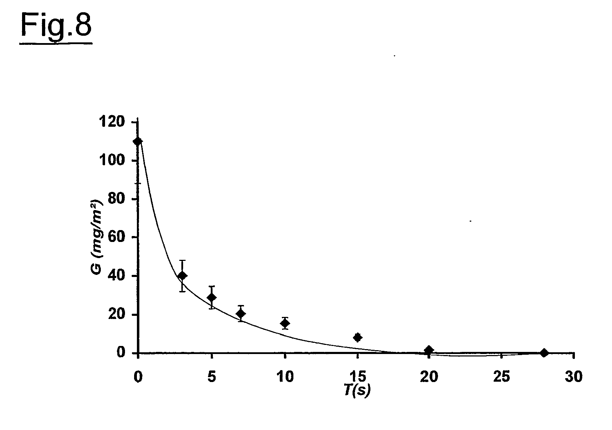

La figure 8 montre l'évolution du grammage en huile résiduelle sur les échantillons prélevés dans la tôle après différents temps de traitement plasma. On constate qu'un temps de 20 secondes est suffisant pour nettoyer la tôle.

### Exemple 3

On renouvelle l'essai de l'exemple 1 en recouvrant la tôle d'acier d'une couche de 150 mg/m² de l'huile Quaker Tinnol N200.

On traite des échantillons prélevés dans la tôle en leur appliquant différents champs électriques. On obtient les spectres XPS des surfaces de ces échantillons, et d'échantillons de références, et on calcule les rapports Fe/C et O/C par intégration des pics correspondants.

Les résultats obtenus et les conditions des tests sont rassemblés dans le tableau suivant :

| | Temps de traitement (s) | Oxygène (l/h) | Fe/C |
|---|---|---|---|
| Référence huilée | | - | 0 |
| Référence dégraissée solvant | | - | 0,30 |
| Plasma avec générateur de courant continu pulsé à 10 kHz | 75 180 | 650 | 0,19 0,23 |
| Plasma avec générateur de courant continu pulsé à 20 kHz | 45 | 650 | 0,20 |
| Plasma avec générateur de courant continu pulsé à 40 kHz | 22 | 650 | 0,26 |
| Plasma avec générateur de courant continu pulsé à 100 kHz | 10 | 650 | 0,23 |

Plus le rapport Fe/C est élevé, plus la surface du matériau est propre.

Si on compare les trois résultats obtenus avec le générateur de courant continu pulsé, on constate la notable amélioration de la vitesse du traitement de dégraissage lorsque les impulsions de tension positives ont une fréquence d'au moins 20 kHz.

Par ailleurs, on constate que, pour une fréquence de 40 kHz, on dégraisse totalement la tôle au bout de 22 secondes, tandis qu'à une fréquence de 100 kHz, il ne faut plus que 10 secondes pour parvenir au même résultat.

## Revendications

1. Procédé de nettoyage en continu de la surface d'un matériau (2) enduit d'une substance organique, **caractérisé en ce qu'**il comprend les étapes consistant à introduire ledit matériau (2) dans une zone de traitement alimentée par un flux gazeux comprenant de l'oxygène, à mettre ledit matériau (2) à la masse, et à générer un plasma en imposant un champ électrique entre la surface dudit matériau (2) et au moins une électrode (3) recouverte de diélectrique, ledit champ électrique étant pulsé et comprenant une succession d'impulsions de tension positives et négatives par rapport audit matériau (2), la tension maximale des impulsions positives U+ étant supérieure à la tension d'amorçage de l'arc Ua, et la tension maximale des impulsions négatives U- en valeur absolue étant inférieure à la tension d'amorçage Ua.

2. Procédé selon la revendication 1, **caractérisé en ce que** le front de montée en tension dudit champ est inférieur ou égal à 600 ns.

3. Procédé selon l'une quelconque des revendications 1 ou 2, **caractérisé en ce que** la fréquence des impulsions positives est supérieure ou égale à 20 kHz.

4. Procédé selon l'une quelconque des revendications 1 à 3, **caractérisé en ce que** ledit flux gazeux est constitué d'air ou d'oxygène.

5. Procédé selon l'une quelconque des revendications 1 à 4, **caractérisé en ce que** ledit matériau (2) est un matériau métallique.

6. Procédé selon la revendication 5, **caractérisé en ce que** ledit matériau (2) est un acier au carbone.

7. Procédé selon la revendication 5 ou 6, **caractérisé en ce que** ladite substance organique est une huile de protection temporaire contre la corrosion ou une émulsion mécanique instable.

8. Procédé selon l'une quelconque des revendications 1 à 7, **caractérisé en ce que** le matériau (2) esf sous forme d'une bande en défilement, et **en ce que** les différentes étapes du procédé sont réalisées en continu au moyen d'installations disposées successivement sur le trajet de la bande en défilement.

9. Générateur (4) pouvant être utilisé pour la mise en oeuvre du procédé selon l'une quelconque des revendications 1 à 8, **caractérisé en ce qu'**il comprend une source d'alimentation basse tension délivrant des impulsions basse tension de tension inférieure à 1000 Volts à une fréquence de 1 à 200 kHz, et **en ce qu'**il comprend des composants permettant de transformer lesdites impulsions basse tension en impulsions haute tension.

10. Générateur selon la revendication 9, **caractérisé en ce que** le front de montée en tension est inférieur ou égal à 600 ns.

11. Dispositif pour la mise en oeuvre du procédé selon la revendication 8, comprenant des moyens de défilement (1) de ladite bande (2) reliés à la masse, une série d'électrodes (3) recouvertes de diélectrique disposées en face de la surface à traiter de ladite bande (2), ces électrodes (3) étant reliées à un générateur (4) selon la revendication 9 ou 10, des moyens d'alimentation en gaz disposés à proximité de la surface de la bande (2), et des moyens d'extraction des gaz de décomposition de la substance organique enduisant la bande (2).

12. Dispositif selon la revendication 11, **caractérisé en ce que** ledit diélectrique est constitué d'alumine.

13. Dispositif selon la revendication 11, **caractérisé en ce que** ledit diélectrique est constitué d'une stumatite.

## Claims

1. Method for continuous cleaning of the surface of a material (2) coated with an organic substance, **characterised in that** it includes steps which comprise introducing said material (2) into a treatment zone supplied with a gaseous flux comprising oxygen, earthing said material (2) and generating a plasma by applying an electrical field between the surface of said material (2) and at least one electrode (3) which is covered with a dielectric, said electrical field being pulsed and comprising a series of voltage pulses which are positive and negative relative to said material (2), the maximum voltage of the positive U+ pulses being greater than the arc-over voltage of the arc Ua, and the maximum voltage of the negative pulses U- as an absolute value being less than the arc-over voltage Ua.

2. Method according to claim 1, **characterised in that** the voltage rising edge of said field is less then or equal to 600 ns.

3. Method according to any of the claims 1 or 2, **characterised in that** the frequency of the positive pulses is greater than or equal to 20 kHz.

4. Method according to any of the claims 1 to 3, **characterised in that** said gaseous flux comprises air or oxygen.

5. Method according to any of the claims 1 to 4, **characterised in that** said material (2) is a metallic material.

6. Method according to claim 5, **characterised in that** said material (2) is a carbon steel.

7. Method according to claim 5 or 6, **characterised in that** said organic substance is an oil for temporary protection against corrosion or an unstable mechanical emulsion.

8. Method according to any of the claims 1 to 7, **characterised in that** the material (2) is in the form of an unwinding strip, and **in that** the various steps of the method are produced continuously by means of installations disposed successively over the route of the unwinding strip.

9. Generator (4) which is able to be used for implementing the method according to any of the claims 1 to 8, **characterised in that** it includes a low voltage supply source which delivers low voltage pulses of a voltage less than 1000 volts at a frequency of 1 to 200 kHz, and **in that** it includes components which make it possible to convert said low voltage pulses into high voltage pulses.

10. Generator according to claim 9, **characterised in that** the voltage rising edge is less then or equal to 600 ns.

11. Device for implementing the method according to claim 8, comprising means (1) connected to earth for unwinding said strip (2), a series of electrodes (3) covered with a dielectric and disposed opposite the surface to be treated of said strip (2), these electrodes (3) being connected to a generator (4) according to claim 9 or 10, gas supply means disposed in the vicinity of the surface of the strip (2) and means for extracting the gases from the decomposition of the organic substance coating the strip (2).

12. Device according to claim 11, **characterised in that** said dielectric is formed by alumina.

13. Device according to claim 11, **characterised in that** said dielectric is formed by a stumatite.

## Patentansprüche

1. Verfahren zur Durchlaufreinigung der Oberfläche eines Werkstoffes (2), der von einer organischen Substanz bedeckt ist, **dadurch gekennzeichnet, dass** es die Schritte umfasst, die darin bestehen, den genannten Werkstoff (2) in einen Behandlungsbereich einzuführen, in den ein Sauerstoff enthaltender Gasstrom eingeleitet wird, den genannten Werkstoff (2) an Masse anzulegen und ein Plasma zu erzeugen, indem ein elektrisches Feld zwischen der Oberfläche des genannten Werkstoffes (2) und mindestens einer mit Dielektrikum beschichteten Elektrode (3) erzeugt wird, wobei das genannte elektrische Feld gepulst ist und eine Folge relativ zum genannten Werkstoff (2) positiver und negativer Spannungsimpulse umfasst, wobei die maximale Spannung der positven Impulse U+ höher ist, als die Zündspannung des Lichtbogens Ua, und der Absolutwert der Maximalspannung der negativen Impulse U- geringer ist, als die Zündspannung Ua.

2. Verfahren nach Patentanspruch 1, **dadurch gekennzeichnet, dass** die Spannungsanstiegsflanke des genannten Feldes geringer oder gleich 600 ns ist.

3. Verfahren nach irgendeinem der Patentansprüche 1 oder 2, **dadurch gekennzeichnet, dass** die Frequenz der positiven Impulse höher oder gleich 20 kHz ist.

4. Verfahren nach irgendeinem der Patentansprüche 1 bis 3, **dadurch gekennzeichnet, dass** der genannte Gasstrom aus Luft oder Sauerstoff besteht.

5. Verfahren nach irgendeinem der Patentansprüche 1 bis 4, **dadurch gekennzeichnet, dass** der genannte Werkstoff (2) ein metallischer Werkstoff ist.

6. Verfahren nach Patentanspruch 5, **dadurch gekennzeichnet, dass** der genannte Werkstoff (2) ein Kohlenstoffstahl ist.

7. Verfahren nach Patentanspruch 5 oder 6, **dadurch gekennzeichnet, dass** die genannte organische Substanz ein Öl zum vorübergehenden Schutz vor Korrosion ist oder eine instabile mechanische Emulsion.

8. Verfahren nach irgendeinem der Patentansprüche 1 bis 7, **dadurch gekennzeichnet, dass** der Werkstoff (2) in Form eines durchlaufenden Bandes vorliegt und **dadurch**, dass die verschiedenen Schritte des Verfahrens im Durchlauf mit Hilfe von Anlagen ausgeführt werden, die nacheinander auf der Bahn des durchlaufenden Bandes angeordnet sind.

9. Generator (4), der zur Ausführung des Verfahrens nach irgendeinem der Patentansprüche 1 bis 8 verwendet werden kann, **dadurch gekennzeichnet, dass** er eine Niederspannungsquelle umfasst, die Niederspannungsimpulse mit einer Spannung von unter 1000 Volt bei einer Frequenz zwischen 1 und 200 kHZ liefert, und **dadurch**, dass er Komponenten umfasst, die erlauben, die genannten Niederspannungsimpulse in Hochspannungsimpulse umzuformen.

10. Generator nach Patentanspruch 9, **dadurch gekennzeichnet, dass** die Spannungsanstiegsflanke geringer oder gleich 600 ns ist.

11. Vorrichtung zur Ausführung des Verfahrens nach Patentanspruch 8, Mittel für den Durchlauf (1) des genannten Bandes (2), die an Masse angelegt sind, umfassend, eine Reihe von mit Dielektrikum beschichteten Elektroden (3), die der zu behandelnden Oberfläche des genannten Bandes (2) gegenüber angeordnet sind, wobei diese Elektroden (3) an einen Generator (4) nach Patentanspruch 9 oder 10 angeschlossen sind, Gaseinleitungsmittel, die in der Nähe der Oberfläche des Bandes (2) angeordnet sind, und Mittel zur Abführung der Gase aus der Zersetzung der organischen Substanz, die das Band (2) bedeckt.

12. Vorrichtung nach Patentanspruch 11, **dadurch gekennzeichnet, dass** das genannte Dielektrikum aus Aluminiumoxid besteht.

13. Vorrichtung nach Patentanspruch 11, **dadurch gekennzeichnet, dass** das genannte Dielektrikum aus einem Stumatit besteht.
